# EUROPÄISCHE PATENTSCHRIFT

(11) **EP 2 565 608 B1**
(45) Veröffentlichungstag und Bekanntmachung des Hinweises auf die Patenterteilung: **26.04.2017**
(21) Anmeldenummer: 11179536.5
(22) Anmeldetag: 31.08.2011
(51) Int. Cl.: G01K 7/22, G01K 7/24, H01L 29/78, H01L 23/34, H01L 23/373, H01L 23/00

(54) **Halbleiterbauelement in Chipbauweise**
Semiconductor component in chip design
Composant semi-conducteur de type puce

(43) Veröffentlichungstag der Anmeldung: 06.03.2013
(73) Patentinhaber: Siemens Aktiengesellschaft, 80333 München (DE)
(72) Erfinder: Weis, Benno, 91334 Hemhofen (DE)

(56) Entgegenhaltungen:
- DE-A1- 10 361 714
- JP-A- 57 012 332
- JP-A- 2002 081 996
- US-A- 4 830 976
- US-A- 5 847 436

## Beschreibung

Die Erfindung betrifft ein Halbleiterbauelement in Chipbauweise mit einem ersten und einem zweiten Leistungsanschluss und einem Gateanschluss.

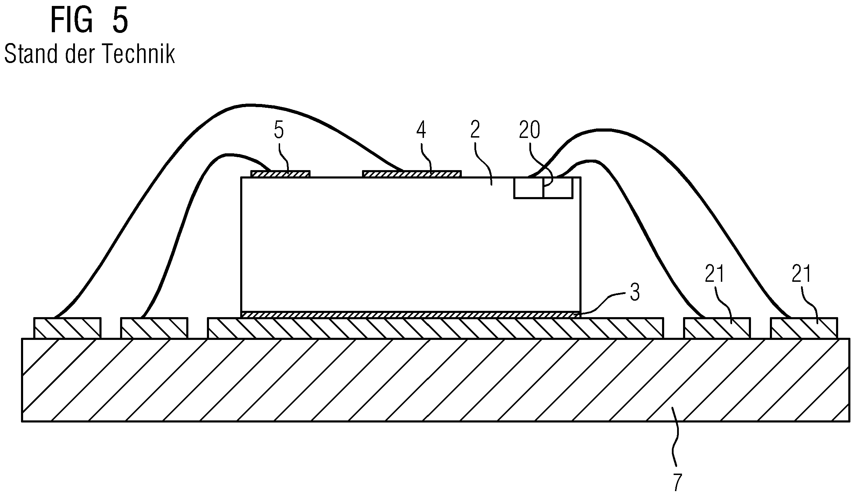

Die Erfindung kommt insbesondere in leistungselektronischen Applikationen zum Einsatz. Hierbei können als Halbleiterbauelemente spannungsgesteuerte Leistungshalbleiter wie IGBT und MOSFET beispielhaft verwendet werden. Zur Temperaturbestimmung weisen derartige Halbleiterbauelemente häufig eine Sensordiode auf, die in den Chip des Halbleiter-Bauelements integriert ist, extern kontaktiert ist und mit einem Messstrom beaufschlagt wird. Ein solches Halbleiterbauelement ist in FIG 5 gezeigt, wo ein Chip 2 auf einem Direct Bonded Copper-Substrat 7 aufgebracht ist und einen ersten Leistungsanschluss 3, einen zweiten Leistungsanschluss 4 und einen Gateanschluss 5 aufweist. Die Temperatur des Chips kann mittels einer Sensordiode 20 bestimmt werden, welche über zusätzliche Anschlusskontakte 21 mit einem Strom beaufschlagt werden kann.

DE10361714, US4830976, US5847436, JP57012332 und JP2002081996 sind Beispiele von bekannten Schaltungsanordnungen zur Bestimmung der Temperatur eines Chips eines Halbleiterbauelements, wobei das Halbleiterbauelement (z.B. IGBT oder MOSFET) einen ersten und einen zweiten Leistungsanschluss und einen Gateanschluss aufweist, sowie einen temperaturabhängigen ohmschen Widerstand zur Bestimmung der Temperatur des Chips, der eine elektrische Verbindung zwischen dem Gateanschluss und dem ersten oder zweiten Leistungsanschluss herstellt.

Der Erfindung liegt die Aufgabe zugrunde, die Temperaturbestimmung von Halbleiterbauelementen zu vereinfachen.

Diese Aufgabe wird durch eine Schaltungsanordnung zur Bestimmung der Temperatur eines Chips eines Halbleiterbauelements gemäß Anspruch 1 gelöst.

Von Vorteil ist dabei, dass die Temperaturbestimmung des Halbleiterbauelements mit Hilfe des temperaturabhängigen ohmschen Widerstands ohne zusätzliche externe elektrische Kontakte durchgeführt werden kann. Dies resultiert in einer Kostenersparnis und erlaubt eine übersichtliche Anordnung von mehreren Halbleiterbauelementen, deren Temperatur jeweils separat bestimmbar ist. Dadurch, dass weniger Bonddrähte verwendet werden, erhöht sich die Zuverlässigkeit der Schaltung und ihre Komplexität wird verringert. Insbesondere bei einer Anordnung mit mehreren Halbleiterbauelementen ergeben sich durch Verwendung einer geringeren Anzahl von Bonddrähten zusätzliche Entflechtungsmöglichkeiten.

Die prinzipielle Funktionsweise der erfindungsgemäßen Schaltungsanordnung ist dabei derart, dass das Halbleiterelement sich im eingeschalteten Zustand befindet, wenn zwischen Gateanschluss und zweitem Leistungsanschluss eine bestimmte Spannung anliegt. Damit ein Strom vom ersten Leistungsanschluss zum zweiten Leistungsanschluss fließt, muss dann eine entsprechende Spannung zwischen erstem und zweitem Leistungsanschluss anliegen. Im eingeschalteten Zustand würde ohne den temperaturabhängigen Widerstand nur ein sehr kleiner Leckstrom von beispielsweise weniger als 1 µA vom Gateanschluss zum zweiten Leistungsanschluss fließen. Wird der temperaturabhängige Widerstand nun so bemessen, dass der Strom vom Gateanschluss zum zweiten Leistungsanschluss temperaturabhängig beispielsweise zwischen 10 µA und 20 µA liegt, so kann er leicht vom wesentlich kleineren Leckstrom unterschieden werden, ohne dabei unzulässig hohe Verluste zu erzeugen.

Weitere vorteilhafte Ausgestaltungen der erfindungsgemäßen Schaltungsanordnung sind den abhängigen Ansprüchen 2 bis 7 zu entnehmen.

Bei einer vorteilhaften Ausgestaltung der Erfindung ist das Halbleiterbauelement als MOSFET ausgeprägt, der erste Leistungsanschluss als Drainanschluss und der zweite Leistungsanschluss als Sourceanschluss ausgeprägt, wobei der temperaturabhängige Widerstand eine elektrische Verbindung zwischen dem Gateanschluss und dem Sourceanschluss herstellt.

Bei Leistungsanwendungen bieten MOSFETs im Vergleich zu anderen Halbleiterbauelementen die Vorteile kurzer Schaltzeiten, geringer Schaltverluste und nahezu leistungsloser Ansteuerung. Ferner ist bei Leistungsanwendungen oft eine Temperaturüberwachung notwendig. Deren Vereinfachung ist somit besonders interessant.

In einer alternativen Ausgestaltung der Erfindung ist das Halbleiterbauelement als IGBT ausgeprägt, der erste Leistungsanschluss als Kollektoranschluss und der zweite Leistungsanschluss als Emitteranschluss ausgeprägt, wobei der temperaturabhängige Widerstand eine elektrische Verbindung zwischen dem Gateanschluss und dem Emitteranschluss herstellt.

IGBTs zeichnen sich im Vergleich zu unipolaren Halbleiterbauelementen durch gutes Durchlassverhalten, hohe Sperrspannung und hohe Strombelastbarkeit aus. Wie MOSFETs sind sie nahezu leistungslos ansteuerbar. Eine vereinfachte Temperaturbestimmung des IGBT ist wegen ihrer zunehmenden Verwendung in der Leistungselektronik vorteilhaft.

Bei einer vorteilhaften Ausgestaltung der Erfindung ist der temperaturabhängige Widerstand auf der Oberfläche des Chips angebracht. Dadurch können Halbleiterbauelemente nachträglich mit einem temperaturabhängigen Widerstand ausgerüstet werden, ohne dass zusätzliche externe elektrische Kontakte am Halbleiterbauelement zur Bestimmung der Temperatur des Halbleiterbauelements benötigt werden. Der thermische Kontakt des an der Oberfläche aufgebrachten temperaturabhängigen Widerstands kann durch den Einsatz von Wärmeleitpaste gewährleistet werden.

Bei einer alternativen vorteilhaften Ausgestaltung der Erfindung ist der temperaturabhängige Widerstand im Chip integriert. Durch die Integration des temperaturabhängigen Widerstands im Chip ist ein sehr guter thermischer Kontakt zwischen Chip und temperaturabhängigem Widerstand sichergestellt. Folglich kann die Temperatur des Halbleiterbauelements mit sehr großer Präzision bestimmt werden.

Bei einer weiteren vorteilhaften Ausgestaltung der Erfindung besteht der Gateanschluss aus Polysilizium und der temperaturabhängige Widerstand besteht aus Polysilizium. Oft wird der Gateanschluss von Halbleiterbauelementen aus Polysilizium hergestellt, so dass Polysilizium bei der Herstellung von Halbleiterchips ohne Zusatzaufwand verfügbar ist. Somit kann der temperaturabhängige Widerstand sehr kostengünstig aus Polysilizium hergestellt werden. Insbesondere kann das Polysilizium als im Chip integrierter temperaturabhängiger Widerstand, welcher eine elektrische Verbindung zwischen dem Gateanschluss und dem zweiten Leistungsanschluss herstellt, verwendet werden.

Die Schaltungsanordnung gemäß der Erfindung nutzt die Charakteristika des temperaturabhängigen Widerstands, um die Temperatur des Chips zu bestimmen. Dabei können sehr einfache Schaltungsanordnungen angewendet werden, welche beispielsweise lediglich den Strom durch den temperaturabhängigen Widerstand und einen Spannungsabfall am temperaturabhängigen Widerstand bestimmen. Durch Division des Spannungsabfalls durch den fließenden Strom kann der elektrische Widerstand dieses Bauteils ermittelt werden und bei Kenntnis der bauteilspezifischen Abhängigkeit des Widerstands von der Temperatur auf die Temperatur geschlossen werden. Gemäß der Erfindung weist die Schaltungsanordnung einen Messwiderstand, eine Spannungsmesseinrichtung zur Messung einer Spannung am Messwiderstand, wobei die Spannung durch einen von der Treiberstufe bereitgestellten Strom erzeugt wird, eine Verarbeitungseinrichtung zur Bestimmung der Temperatur des Chips in Abhängigkeit der gemessenen Spannung auf, sowie einen parallel zum Messwiderstand angeordneten Schalter, mittels welchem der Messwiderstand überbrückbar ist. Zum Ein- und Ausschalten des Halbleiterbauelements stellt die Treiberstufe einen Strom am Gateanschluss bereit, so dass eine Spannung zwischen dem Gateanschluss und dem zweiten Leistungsanschluss aufgebaut wird. Der genannte Strom fließt über einen Messwiderstand und erzeugt eine Spannung, die anhand der Spannungsmesseinrichtung gemessen wird. Somit sind auch der durch den temperaturabhängigen Widerstand fließende Strom und die an ihm anliegende Spannung bestimmbar. Durch Division des Spannungsabfalls durch den fließenden Strom kann die Verarbeitungseinrichtung den Wert des temperaturabhängigen Widerstands bestimmen. Bei Kenntnis der bauteilspezifischen Abhängigkeit des Widerstands von der Temperatur kann die Verarbeitungseinrichtung die Temperatur des Chips bestimmen.

Anstelle der Spannungsmesseinrichtung können alternative Messanordnungen zur Bestimmung des Wertes des temperaturabhängigen Widerstands verwendet werden. Darüber hinaus kann die Verarbeitungseinrichtung bei Erkennen einer Übertemperatur des Halbleiterbauelements dieses abschalten und gegebenenfalls eine Meldung an eine übergeordnete Steuerung abgeben. Die Meldung kann beispielsweise die ermittelte Temperatur beinhalten oder lediglich ein Bit für das Kennzeichnen einer Übertemperatur.

Weiterhin ist es möglich, die Bestimmung der Temperatur des Chips nur dann durchzuführen, wenn das Halbleiterbauelement eingeschaltet ist. Der Messwiderstand kann hochohmig gewählt werden, da dadurch schon ein geringer Strom einen großen Spannungsabfall erzeugt und somit eine präzise Spannungsmessung durch die Spannungsmesseinrichtung ermöglicht. Während des Schaltvorgangs können relativ große, von der Treiberstufe bereitgestellte Ströme fließen. Dabei ist die Treiberstufe möglichst niederohmig mit dem Gateanschluss zu verbinden, um schnelle Schaltvorgänge zu ermöglichen. Insbesondere ist bei MOSFET beziehungsweise IGBT eine intrinsische Kapazität zwischen Gate- und Source- beziehungsweise Emitteranschluss vorhanden. Dabei bestimmt das Produkt von der intrinsischen Kapazität und dem Gatewiderstand die Zeitkonstante des Schaltvorgangs bei MOSFET beziehungsweise IGBT. Deshalb ist es vorteilhaft, den relativ hochohmigen Messwiderstand während der Schaltvorgänge oder wenn keine Temperaturbestimmung durchgeführt wird, mittels des parallel zu ihm angeordneten Schalters zu überbrücken, damit die Zeitkonstante des Schaltvorganges und damit auch die Schaltverluste des Halbleiterbauelements klein sind. Weiterhin kann eine Diode parallel zum Schalter angeordnet sein, wobei die Diode sicherstellt, dass der Messwiderstand bei ausgeschaltetem Halbleiterbauelement immer niederohmig überbrückt ist. Da in der Regel die Schaltperiodendauer kleiner als die thermische Zeitkonstante eines Halbleiterbauelements ist, kann man auch mit nur einer Temperaturbestimmung pro Einschaltimpuls eine genügende Präzision erreichen. Weiterhin kann die niederohmige Überbrückung des Messwiderstands durch den Schalter sofort bei Erkennen eines Schaltbefehles aktiviert werden, so dass ein schnelles Schalten des Halbleiterbauelements gewährleistet wird. Zusätzlich kann ein Widerstand zur Begrenzung des von der Treiberstufe während eines Schaltvorgangs bereitgestellten Stroms verwendet werden, wobei dieser Widerstand niederohmiger als der Messwiderstand ist, um schnelles Schalten zu gewährleisten.

Gemäß einer vorteilhaften Ausgestaltung der Erfindung weist die Treiberstufe der Schaltungsanordnung einen Gatewiderstand zur Begrenzung des beim Ein- und Ausschalten des Halbleiterbauelements fließenden Stroms auf und besagter Gatewiderstand dient als Messwiderstand.

Während der Schaltvorgänge wird der von der Treiberstufe bereitgestellte Gatestrom durch die Verwendung des Gatewiderstands begrenzt. Dabei kann der Gatewiderstand relativ klein gewählt werden, um die Zeitkonstante des Schaltvorganges klein zu halten und damit ein schnelles Schalten zu ermöglichen. Die Zeitkonstante des Schaltvorgangs bei MOSFET beziehungsweise IGBT ist durch das Produkt von der intrinsischen Kapazität zwischen Gate- und Source- beziehungsweise Emitteranschluss und dem Gatewiderstand bestimmt. Der Gatewiderstand wird in dieser Ausgestaltung ebenfalls als Messwiderstand zur Bestimmung der Temperatur verwendet werden und erfüllt somit zwei Funktionen, nämlich die der Strombegrenzung und die der Temperaturmessung.

Im Folgenden wird die Erfindung anhand der in den Figuren dargestellten Ausführungsbeispiele näher beschrieben und erläutert. Es zeigen:
FIG 1 eine Schemadarstellung eines ersten Beispiels eines Halbleiterbauelements
FIG 2 eine Schemadarstellung eines zweiten Beispiels eines Halbleiterbauelements
FIG 3 ein beispielhaftes elektrisches Schaltbild einer Schaltungsanordnung zur Bestimmung der Temperatur eines Chips, das nicht Teil der Erfindung ist
FIG 4 ein elektrisches Schaltbild einer Schaltungsanordnung zur Bestimmung der Temperatur des Chips gemäß der Erfindung
FIG 5 eine Schemadarstellung eines Halbleiterbauelements gemäß Stand der Technik

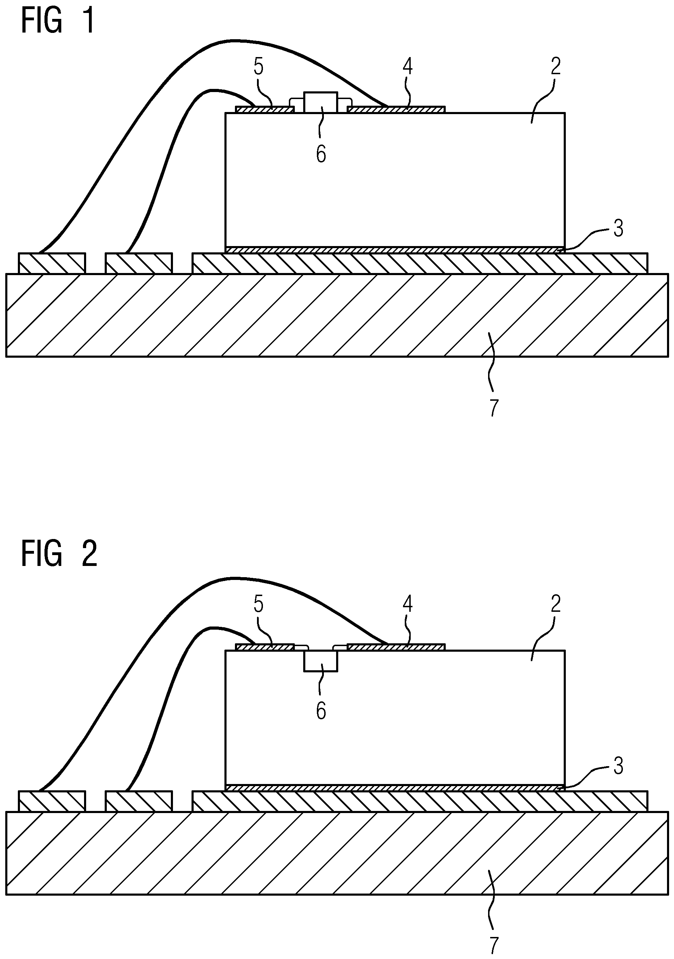

FIG 1 zeigt eine Schemadarstellung eines ersten Beispiels eines Halbleiterbauelements. Das Halbleiterbauelement ist durch einen Chip 2 realisiert und weist einen ersten Leistungsanschluss 3, einen zweiten Leistungsanschluss 4 und einen Gateanschluss 5 auf. Der Chip 2 ist auf ein Direct Bonded Copper-Substrat 7 aufgebracht, welches über drei Kontaktpins für die drei Anschlüsse des Chips verfügt. Auf der Oberfläche des Chips 2 ist zwischen dem zweiten Leistungsanschluss 4 und dem Gateanschluss 5 ein temperaturabhängiger ohmscher Widerstand 6 angebracht, der in thermischem Kontakt mit dem Chip 2 steht. Das Halbleiterbauelement kann insbesondere als MOSFET, IGBT oder ein funktionell ähnliches Halbleiterbauelement ausgeführt sein.

FIG 2 zeigt eine Schemadarstellung eines zweiten Beispiels eines Halbleiterbauelements. Das Halbleiterbauelement ist durch einen Chip 2 realisiert und weist einen ersten Leistungsanschluss 3, einen zweiten Leistungsanschluss 4 und einen Gateanschluss 5 auf. Der Chip 2 ist auf ein Direct Bonded Copper-Substrat 7 aufgebracht, welches über drei Kontaktpins für die drei Anschlüsse des Chips verfügt. Im Chip integriert ist ein temperaturabhängiger ohmscher Widerstand 6 zwischen dem zweiten Leistungsanschluss 4 und dem Gateanschluss 5 angeschlossen. Durch die bauliche Integration des temperaturabhängigen ohmschen Widerstands 6 in den Chip 2 ist ein besonders guter thermischer Kontakt zwischen dem Chip 2 und dem temperaturabhängigen ohmschen Widerstand 6 gewährleistet. Das Halbleiterbauelement kann insbesondere als MOSFET, IGBT oder ein funktionell ähnliches Halbleiterbauelement ausgeführt sein.

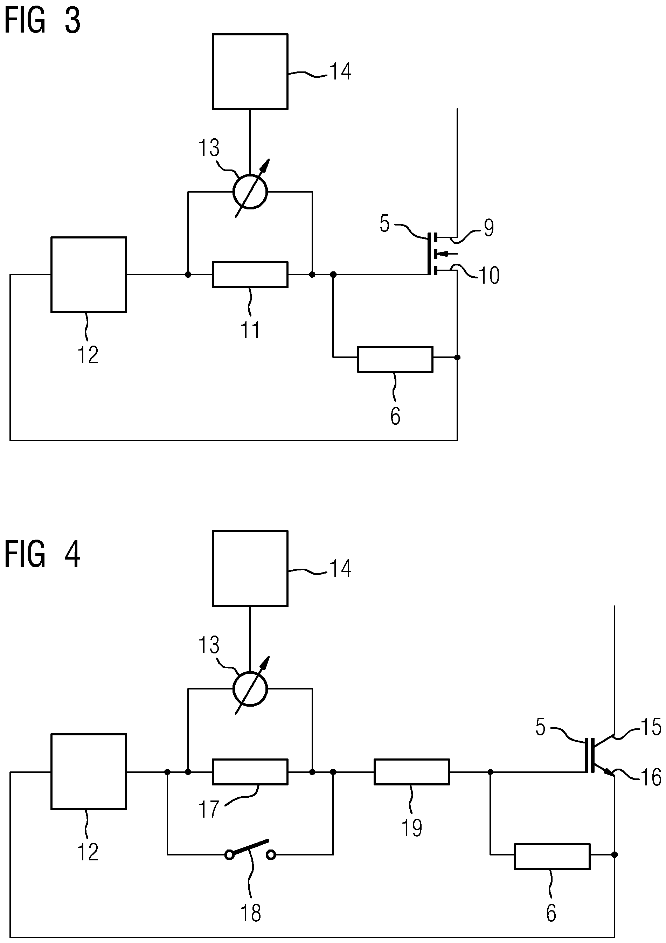

FIG 3 zeigt ein elektrisches Schaltbild einer Schaltungsanordnung zur Bestimmung der Temperatur des Chips, das nicht Teil der Erfindung ist. Das Halbleiterbauelement ist als MOSFET ausgeführt, welches über einen Drainanschluss 9, einen Sourceanschluss 10 und einen Gateanschluss 5 verfügt. Der Sourceanschluss 10 und der Gateanschluss 5 sind dabei über einen temperaturabhängigen ohmschen Widerstand 6 elektrisch verbunden. Das Halbleiterbauelement wird durch eine Treiberstufe 12 ein- und ausgeschaltet, welche hierfür einen Strom vom Gateanschluss 5 zum Sourceanschluss 10 bereitstellen kann. Ein solcher Strom fließt auch durch einen Gatewiderstand 11, welcher zwischen der Treiberstufe 12 und dem Gateanschluss 5 angeordnet ist. Der Gatewiderstand 11 dient als Strombegrenzer bei Schaltvorgängen. Außerdem misst eine Spannungsmesseinrichtung 13, die parallel zum Gatewiderstand 11 geschaltet ist, den am Gatewiderstand 5 auftretenden Spannungsabfall. Eine Verarbeitungseinrichtung 14 wertet die Messungen der Spannungsmesseinrichtung 13 aus und kann damit die Temperatur des temperaturabhängigen ohmschen Widerstands 6 und somit des Halbleiterbauelements bestimmen. Eine Temperaturbestimmung kann beispielsweise bei eingeschaltetem Halbleiterbauelement durchgeführt werden, wobei eine Messung pro Schaltzyklus oft genügend genaue Ergebnisse liefert. Neben dem in FIG 3 gezeigten MOSFET kann das Halbleiterbauelement auch als IGBT oder als ein funktionell ähnliches Halbleiterbauelement ausgeführt sein.

FIG 4 zeigt ein elektrisches Schaltbild einer Schaltungsanordnung zur Bestimmung der Temperatur des Chips gemäß der Erfindung. Das Halbleiterbauelement ist als IGBT ausgeführt, welches über einen Kollektoranschluss 15, einen Emitteranschluss 16 und einen Gateanschluss 5 verfügt. Der Emitteranschluss 16 und der Gateanschluss 5 sind dabei über einen temperaturabhängigen ohmschen Widerstand 6 elektrisch verbunden. Das Halbleiterbauelement wird durch eine Treiberstufe 12 ein- und ausgeschaltet, welche hierfür einen Strom vom Gateanschluss 5 zum Emitteranschluss 16 bereitstellen kann. Ein solcher Strom fließt auch durch einen Messwiderstand 17 und einen Widerstand 19, welche zwischen der Treiberstufe 12 und dem Gateanschluss 5 angeordnet sind. Dabei dient der Widerstand 19 als Strombegrenzer bei Schaltvorgängen. Den Spannungsabfall am Messwiderstand 17 misst eine Spannungsmesseinrichtung 13, die parallel zum Messwiderstand 17 geschaltet ist. Eine Verarbeitungseinrichtung 14 wertet die Messungen der Spannungsmesseinrichtung 13 aus und kann damit die Temperatur des temperaturabhängigen ohmschen Widerstands 6 und somit des Halbleiterbauelements bestimmen. Parallel zum Messwiderstand 17 ist ein Schalter 18 angeordnet, welcher den Messwiderstand 17 überbrücken kann. Diese Überbrückung ist besonders vorteilhaft, wenn während eines Schaltvorganges die Treiberstufe 12 niederohmig mit dem Gateanschluss 5 verbunden sein soll, um kurze Schaltzeiten zu ermöglichen. Daher ist der Widerstand 19 niederohmiger als der Messwiderstand 17 zu wählen. Dies hat auch den Vorteil, dass ein relativ hochohmiger Messwiderstand 17 eine präzisere Spannungsmessung erlaubt. Eine Temperaturbestimmung kann beispielsweise bei eingeschaltetem Halbleiterbauelement durchgeführt werden, wobei eine Messung pro Schaltzyklus oft genügend genaue Ergebnisse liefert. Denkbar ist auch eine Anordnung ohne den Schalter 18, wobei der Messwiderstand 17 und die Spannungsmesseinrichtung 13 nicht mit dem Ausgang der Treiberstufe 12 verbunden sind, sondern mit der positiven Versorgung der Treiberstufe 12. Zum Messen würde man dann die Treiberstufe 12 kurzzeitig hochohmig schalten, womit der Schalter 18 entfallen könnte. Neben dem in FIG 4 gezeigten IGBT kann das Halbleiterbauelement auch als MOSFET oder als ein funktionell ähnliches Halbleiterbauelement ausgeführt sein.

## Patentansprüche

1. Schaltungsanordnung (8) zur Bestimmung der Temperatur eines Chips (2) eines Halbleiterbauelements (1) in Chipbauweise mit
- dem Halbleiterbauelement (1), welches
- einen ersten und einen zweiten Leistungsanschluss (3,4) und einen Gateanschluss (5) und
- einen temperaturabhängigen ohmschen Widerstand (6) zur Bestimmung der Temperatur des Chips (2) aufweist, wobei der temperaturabhängige Widerstand (6) eine elektrische Verbindung zwischen dem Gateanschluss (5) und dem ersten oder zweiten Leistungsanschluss (3,4) herstellt und mit dem Chip (2) in thermischem Kontakt steht,
- einer Treiberstufe (12) zur Ansteuerung des Halbleiterbauelements (1),
**dadurch gekennzeichnet, dass** die Schaltungsanordnung (8) weiter die folgenden Elemente aufweist:
- einen Messwiderstand (17),
- eine Spannungsmesseinrichtung (13) zur Messung einer Spannung am Messwiderstand (17), wobei die Spannung durch einen von der Treiberstufe (12) bereitgestellten Strom erzeugt wird, und
- eine Verarbeitungseinrichtung (14) zur Bestimmung der Temperatur des Chips (2) in Abhängigkeit der gemessenen Spannung und
- ein parallel zum Messwiderstand (17) angeordneter Schalter (18), mittels welchem der Messwiderstand (17) überbrückbar ist.

2. Schaltungsanordnung (8) nach Anspruch 1, wobei die Treiberstufe (12) einen Gatewiderstand (11) zur Begrenzung des beim Ein- und Ausschalten des Halbleiterbauelements (1) fließenden Stroms aufweist und besagter Gatewiderstand (11) als Messwiderstand (17) dient.

3. Schaltungsanordnung (8) nach einem der vorhergehenden Ansprüche, wobei
- das Halbleiterbauelement (1) als MOSFET ausgeprägt ist und
- der ersten Leistungsanschluss (3) als Drainanschluss (9),
- der zweite Leistungsanschluss (4) als Sourceanschluss (10) ausgeprägt ist und
- wobei der temperaturabhängige Widerstand (6) eine elektrische Verbindung zwischen dem Gateanschluss (5) und dem Sourceanschluss (10) herstellt.

4. Schaltungsanordnung (8) nach Anspruch 1 oder 2, wobei
- das Halbleiterbauelement (1) als IGBT ausgeprägt ist und
- der ersten Leistungsanschluss (3) als Kollektoranschluss (15),
- der zweite Leistungsanschluss (4) als Emitteranschluss (16) ausgeprägt ist und
- wobei der temperaturabhängige Widerstand (6) eine elektrische Verbindung zwischen dem Gateanschluss (5) und dem Emitteranschluss (16) herstellt.

5. Schaltungsanordnung (8) nach einem der vorhergehenden Ansprüche,
wobei der temperaturabhängige Widerstand (6) auf der Oberfläche des Chips (2) angeordnet ist.

6. Schaltungsanordnung (8) nach einem der Ansprüche 1-4,
- wobei der temperaturabhängige Widerstand (6) im Chip (2) integriert ist.

7. Schaltungsanordnung (8) nach einem der vorhergehenden Ansprüche,
- wobei der Gateanschluss (5) aus Polysilizium besteht und
- der temperaturabhängige Widerstand (6) aus Polysilizium besteht.

## Claims

1. Circuit arrangement (8) for determining the temperature of a chip (2) of a semiconductor component (1) in chip design, having
- the semiconductor component (1), which has
- a first and a second power terminal (3, 4) and a gate terminal (5), and
- a temperature-dependent ohmic resistor (6) for determining the temperature of the chip (2), wherein the temperature-dependent resistor (6) forms an electrical connection between the gate terminal (5) and the first or second power terminal (3, 4) and is in thermal contact with the chip (2),
- a driver stage (12) for actuating the semiconductor component (1),
**characterised in that** the circuit arrangement (8) also has the following elements:
- a shunt resistor (17),
- a voltage measurement unit (13) for measuring a voltage at the shunt resistor (17), wherein the voltage is generated by a current supplied by the driver stage (12), and
- a processing unit (14) for determining the temperature of the chip (2) as a function of the measured voltage, and
- a switch (18) arranged in parallel with the shunt resistor (17), by means of which the shunt resistor (17) can be bypassed.

2. Circuit arrangement (8) according to claim 1, wherein the driver stage (12) has a gate resistor (11) for limiting the current that flows when the semiconductor component (1) is switched on and off, said gate resistor (11) functioning as a shunt resistor (17).

3. Circuit arrangement (8) according to one of the preceding claims, wherein
- the semiconductor component (1) is realised as a MOSFET and
- the first power terminal (3) is realised as a drain terminal (9),
- the second power terminal (4) is realised as a source terminal (10) and
- wherein the temperature-dependent resistor (6) forms an electrical connection between the gate terminal (5) and the source terminal (10).

4. Circuit arrangement (8) according to claim 1 or 2, wherein
- the semiconductor component (1) is realised as an IGBT and
- the first power terminal (3) is realised as a collector terminal (15),
- the second power terminal (4) is realised as an emitter terminal (16) and
- wherein the temperature-dependent resistor (6) forms an electrical connection between the gate terminal (5) and the emitter terminal (16).

5. Circuit arrangement (8) according to one of the preceding claims,
wherein the temperature-dependent resistor (6) is arranged on the surface of the chip (2).

6. Circuit arrangement (8) according to one of claims 1-4,
- wherein the temperature-dependent resistor (6) is integrated in the chip (2).

7. Circuit arrangement (8) according to one of the preceding claims,
- wherein the gate terminal (5) is made of polysilicon and
- the temperature-dependent resistor (6) is made of polysilicon.

## Revendications

1. Montage ( 8 ) de détermination de la température d'une puce ( 2 ) d'un composant ( 1 ) à semiconducteur en mode de construction puce, comprenant
- le composant ( 1 ) à semiconducteur, qui a
- une première et une deuxième bornes ( 3, 4 ) de puissance et une borne ( 5 ) de grille et
- une résistance ( 6 ) ohmique, qui dépend de la température, pour déterminer la température de la puce ( 2 ), la résistance ( 6 ) qui dépend de la température ménageant une liaison électrique entre la borne ( 5 ) de grille et la première ou la deuxième borne ( 3, 4 ) de puissance et étant en contact thermique avec la puce ( 2 ),
- un étage ( 12 ) de commande pour commander le composant ( 1 ) à semiconducteur,
**caractérisé en ce que** le montage ( 8 ) a, en outre, les éléments suivantes :
- une résistance ( 17 ) de mesure,
- un dispositif ( 13 ) de mesure de la tension pour mesurer une tension aux bornes de la résistance ( 17 ) de mesure, la tension étant produite par un courant mis à disposition par l'étage ( 12 ) de commande et
- un dispositif ( 14 ) de traitement pour déterminer la température de la puce ( 2 ) en fonction de la tension mesurée et
- un interrupteur ( 18 ), qui est monté en parallèle avec la résistance ( 17 ) de mesure et au moyen duquel la résistance ( 17 ) de mesure peut être shuntée.

2. Montage ( 8 ) suivant la revendication 1, dans lequel l'étage ( 12 ) de commande a une résistance ( 11 ) de grille pour limiter le courant passant lors de la mise en circuit et hors circuit du composant ( 1 ) à semiconducteur et ladite résistance ( 11 ) de grille sert de résistance ( 17 ) de mesure.

3. Montage ( 8 ) suivant l'une des revendications précédentes, dans lequel
- le composant ( 1 ) à semiconducteur est constitué en MOSFET et
- la première borne ( 3 ) de puissance est constituée en borne ( 9 ) de drain,
- la deuxième borne ( 4 ) de puissance est constituée en borne ( 10 ) de source et
- dans lequel la résistance ( 6 ) qui dépend de la température ménage une liaison électrique entre la borne ( 5 ) de grille et la borne ( 10 ) de source.

4. Montage ( 8 ) suivant la revendication 1 ou 2, dans lequel
- le composant ( 1 ) à semiconducteur est constitué en IGBT et
- la première borne ( 3 ) de puissance est constituée en borne ( 15 ) de collecteur,
- la deuxième borne ( 4 ) de puissance est constituée en borne ( 16 ) d'émetteur et
- dans lequel la résistance ( 6 ) en fonction de la température ménage une liaison électrique entre la borne ( 5 ) de grille et la borne ( 16 ) d'émetteur.

5. Montage ( 8 ) suivant l'une des revendications précédentes, dans lequel la résistance ( 6 ) qui dépend de la température est mise sur la surface de la puce ( 2 ).

6. Montage ( 8 ) suivant l'une des revendications 1 à 4,
- dans lequel la résistance ( 6 ) qui dépend de la température est intégrée à la puce ( 2 ).

7. Montage ( 8 ) suivant l'une des revendications précédentes,
- dans lequel la borne ( 5 ) de grille est en polysilicium et
- la résistance ( 6 ) qui dépend de la température est en polysilicium.
